# EUROPÄISCHE PATENTSCHRIFT

(11) **EP 3 947 946 B1**
(45) Veröffentlichungstag und Bekanntmachung des Hinweises auf die Patenterteilung: **28.02.2024**
(21) Anmeldenummer: 20714183.9
(22) Anmeldetag: 24.03.2020
(51) Int. Cl.: F02D 41/14, F02D 41/22, G01N 27/417, F02D 41/20, F02D 41/28

(54) **VERFAHREN ZUR DIAGNOSE VON ABGASSENSOREN**
METHOD FOR DIAGNOSING EXHAUST GAS SENSORS
PROCÉDÉ DE DIAGNOSTIC DE CAPTEURS DE GAZ D'ÉCHAPPEMENT

(30) Priorität: 04.04.2019 DE 102019204827
(43) Veröffentlichungstag der Anmeldung: 09.02.2022
(73) Patentinhaber: Robert Bosch GmbH, 70442 Stuttgart (DE)
(72) Erfinder: LEDERMANN, Bernhard, 71263 Weil Der Stadt (DE); BAUMANN, Fabian, 71563 Affalterbach (DE); BEVOT, Claudius, 70197 Stuttgart (DE); DITTMER-GOBELJIC, Danka, 70191 Stuttgart (DE)
(86) Internationale Anmeldenummer: PCT/EP2020/058055
(87) Internationale Veröffentlichungsnummer: WO 2020/200896

(56) Entgegenhaltungen:
- DE-A1-102012 201 467
- JP-A- 2017 089 440
- US-A1- 2015 068 278

## Beschreibung

### Stand der Technik

Es sind bereits Möglichkeiten zur Diagnose einer Lambdasonde bekannt, beispielsweise aus der DE19729696 A1, die ein Verfahren zur Funktionskontrolle einer Lambdasonde vorschlägt, bei dem vorgesehen ist, dass der Innenwiderstand der Sondenkeramik gemessen wird, mit einem in Abhängigkeit von der Temperatur des zu detektierenden Gases und der Heizleistung der Sondenheizung ermittelten Sollwert verglichen wird und ein Fehlersignal resultiert, falls der gemessene Wert den Sollwert überschreitet.

### Vorteile der Erfindung

Die vorliegende Erfindung hat zum Ziel, das Vorliegen eines Kurzschlusses oder Nebenschlusses einer elektrischen Leitung einer Breitband-Lambdasonde stets sicher diagnostizieren zu können. Dies wird durch die Merkmale der unabhängigen Ansprüche erreicht.

Es ist insbesondere vorgesehen, dass Kurzschlüsse oder Nebenschlüsse zum einen dadurch festgestellt werden können, dass das an dem Anschluss anliegende elektrische Potenzial außerhalb vorgegebener Schranken liegt. Hierbei kann es sich beispielsweise um Schranken handeln, die durch Potenziale gegeben sind, die im regulären Betrieb der Breitband-Lambdasonde, wenn also kein Kurzschluss vorliegt, gerade nicht mehr zu erwarten sind.

Der Vergleich des an dem Anschluss anliegenden elektrischen Potenzials mit vorgegebenen Schranken kann vorzugsweise mit Hardware-Komparatoren erfolgen, da diese sehr schnell arbeiten, sodass Schäden an der Breitband-Lambdasonde und/oder an der Auswerte- und Steuereinheit, die im derartigen Fehlerfall andernfalls zu befürchten wären, sicher vermieden werden können.

Die Erfindung sieht weiterhin insbesondere vor, dass Kurzschlüsse oder Nebenschlüsse auch dann festgestellt werden, wenn der in den Anschluss tatsächlich fließende elektrische Strom sich von einem Sollwert um mehr als einen Schwellwert unterscheidet. Dieser Fall ist grundsätzlich auch möglich, ohne dass das an dem Anschluss anliegende elektrische Potenzial außerhalb der oben erwähnten vorgegebenen Schranken liegt, also ohne dass ein Kurzschluss nach dem vorangehend Geschilderten bereits erkannt werden könnte. Es können mit dem erfindungsgemäßen Verfahren also sämtliche Kurzschlüsse und Nebenschlüsse erkannt werden.

Je nachdem, ob der in den Anschluss fließende elektrische Strom größer oder kleiner als der Sollwert ist, kann in diesem Fall auf einen Kurzschluss nach Masse oder auf einen Kurzschluss zu einem positiven Potenzial geschlossen werden.

Es ist insbesondere möglich, dass der Sollwert durch den Stromwert gegeben ist, der für eine mit dem Anschluss verbundene Konstant-Stromquelle der Steuer- und Auswerteeinheit spezifiziert ist. Die Verbindung zwischen dem Anschluss und der Konstant-Stromquelle kann beispielsweise über eine elektrochemische Zelle der Breitband-Lambdasonde erfolgen, die über zwei elektrische Leitungen der Breitband-Lambdasonde, mit dem Anschluss und einem weiteren Anschluss der Signal- und Auswerteeinheit verbunden ist.

Ist die Beschaltung der Breitband-Lambdasonde komplexer als im vorangehenden Fall wird der Sollwert auf Basis anderer gegebener Vorinformationen und/oder auf Basis von Messungen und/oder auf Basis von Berechnungen ermittelt.

Bei dem Sollwert kann es sich um einen von Null verschiedenen Stromwert handeln. Andererseits kann es auch zulässig sein, dass es sich um den Wert 0µA handelt.

Es ist insbesondere möglich, dass der Schwellwert durch eine erwartete Messgenauigkeit gegeben ist, beispielsweise 2 µA oder weniger.

Es ist erfindungsgemäß vorgesehen, dass die Breitband-Lambdasonde vier elektrische Leitungen aufweist und die Auswerte- und Steuereinheit vier Anschlüsse aufweist, wobei jeweils eine Leitung mit einem Anschluss verbunden ist. Die Diagnose kann dann zyklisch für alle Leitungen durchgeführt werden, also insbesondere in einer bestimmten Reihenfolge nacheinander wiederkehrend. Eine Weiterverarbeitung dieser Informationen kann dazu genutzt werden, eine Kurzschlussspannung und einen Kurzschlusswiderstand Rk zu ermitteln, und es kann leitungsselektiv das Vorliegen eines Kurzschlusses (Rk < 1 Ohm) von dem Vorliegen eines Nebenschlusses (1 MOhm > Rk > 1Ohm) unterschieden werden.

Hat der Widerstand, der formal als Kurzschlusswiderstand erscheint, einen Widerstandswert von > 1 MOhm, wird insbesondere vom fehlerfreien Fall ausgegangen, d.h. an dieser elektrischen Verbindung der Breitband-Lambdasonde liegt weder ein Kurzschluss noch ein Nebenschluss vor; sie ist intakt.

Zeichnung
- Figur 1: zeigt eine Breitband-Lambdasonde und eine mit ihr verbundene Auswerte- und Steuereinheit
- Figur 2: zeigt ein Flussdiagramm eines Ausführbeispiels des erfindungsgemäßen Verfahrens
- Figur 3: erläutert die Anordnung aus Figur 1 im Fehlerfall

### Beschreibung der Ausführungsbeispiele

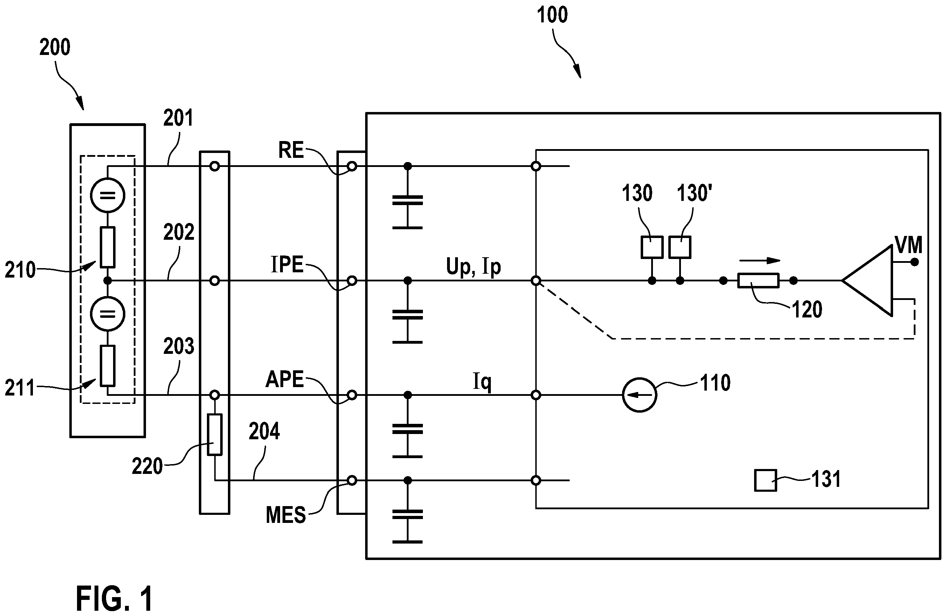

Die Figur 1 zeigt eine Auswerte- und Steuereinheit 100, die über vier ihrer elektrischen Anschlüsse RE, IPE, APE, MES mit vier elektrischen Leitungen 201 - 204 einer Breitband-Lambdasonde 200 verbunden ist. Die elektrischen Leitungen 201 - 204 der Breitband-Lambdasonde 200 führen zu Elektroden einer elektrochemischen Nernstzelle 210 und einer elektrochemischen Pumpzelle 211 der Breitband-Lambdasonde 200 und zu einem ohmschen Widerstand 220 der Breitband-Lambdasonde 200.

Details der Breitband-Lambdasonde können beispielsweise wie in der DE 10 2011 007 068 A1 angegeben ausgeführt sein.

Im Beispiel weist die Auswerte- und Steuereinheit 100 eine Konstantstromquelle 110 auf, die über entsprechende Schalter (nicht dargestellt) mit den Anschlüssen RE, IPE, APE,

MES der Auswerte- und Steuereinheit 100 verbindbar ist und weist eine Strommesseinrichtung 120 auf, die über andere Schalter (nicht dargestellt) ebenfalls mit den Anschlüssen RE, IPE, APE, MES der Auswerte- und Steuereinheit 100 verbindbar ist.

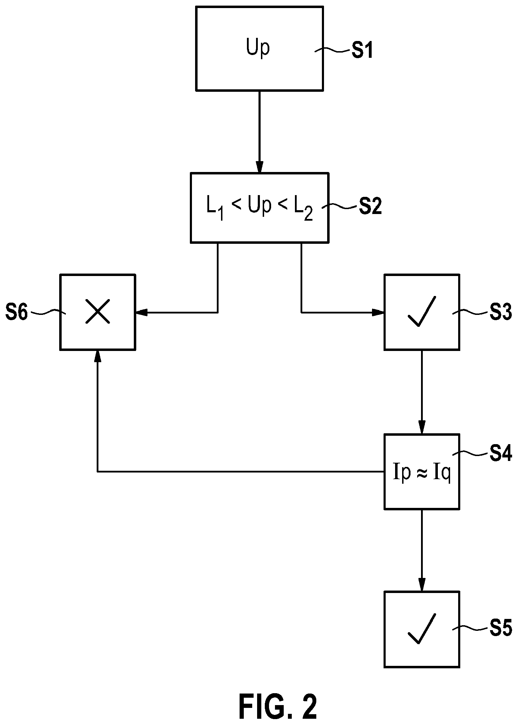

Im Beispiel wird nach Start der Elektronik zunächst das Potenzial Up an dem Anschluss IPE der Auswerte und Steuereinheit gemessen (Verfahrensschritt S1, siehe Figur 2).

Sodann wird in diesem Beispiel mittels Hardware-Komparatoren 130, 130` festgestellt, dass dieses Potenzial Up innerhalb vorgegebener Schranken L1, L2 liegt (Verfahrensschritt S2).

Nachdem durch passives und/oder aktives Beheizen des Breitband-Lambdasonde sichergestellt ist, dass die elektrochemischen Zellen ausreichend niederohmig sind, wird die Konstantstromquelle 110 der Auswerte- und Steuereinheit 100 mit dem Anschluss APE verbunden und die Strommesseinrichtung 120 der Auswerte- und Steuereinheit 100 mit dem Anschluss IPE verbunden (Verfahrensschritt S3).

Der mit der Strommesseinrichtung 120 gemessene Wert Ip wird mit dem für die Konstantstromquelle 110 spezifizierten Wert Iq verglichen, beispielsweise mittels einer Software der Auswerte- und Steuereinheit 100 (Verfahrensschritt S4). In diesem Beispiel stellt der Wert Iq einen in einer Einrichtung 131 zur Bestimmung eines Sollwerts abgelegten Wert dar.

Im Beispiel stimmen die Werte Ip, Iq überein. Es wird also insgesamt geschlossen, dass an den mit dem Anschluss IPE verbundenen Leitung der Breitband-Lambdasonde 200 weder ein Kurzschluss noch ein Nebenschluss vorliegt (Verfahrensschritt S5).

Das Verfahren wäre hingegen zu dem Schluss gelangt, dass ein Kurzschluss oder ein Nebenschluss vorliegt, wenn entweder das Potenzial Up außerhalb vorgegebener Schranken gelegen hätte oder der mit der Strommesseinrichtung 120 gemessene Wert Ip sich von dem für die Konstantstromquelle 110 spezifizierten Wert Iq um mehr als einen Schwellwert unterschieden hätte. Der entsprechende Fehler wäre in diesem Fall beispielsweise in einen Fehlerspeicher der Auswerte- und Steuereinheit oder in den Fehlerspeicher eines mit der Auswerte- und Steuereinheit verbundenen Steuergeräts eingetragen worden (Verfahrensschritt S6).

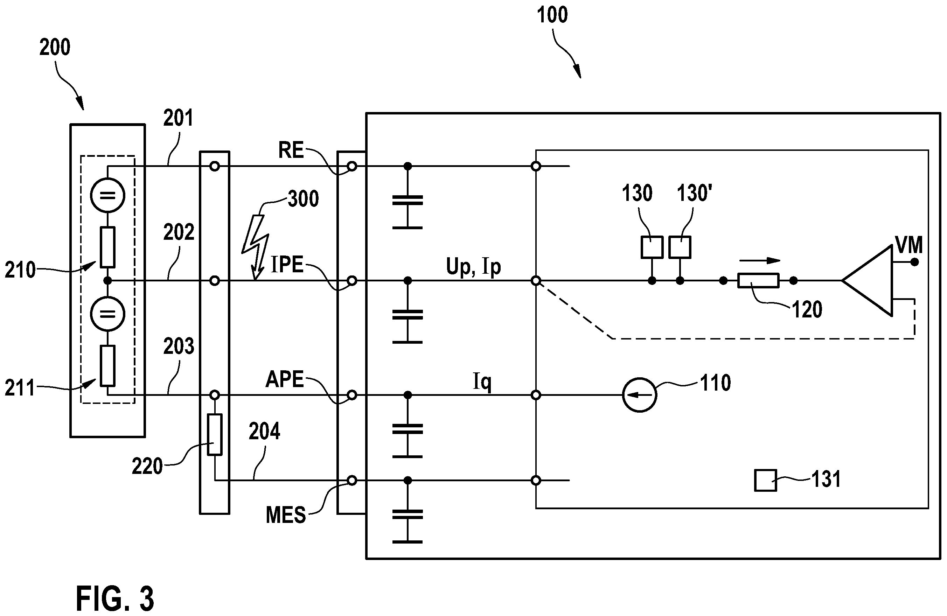

Die Figur 3 erläutert die Anordnung aus Figur 1 im Fehlerfall, in dem zwischen der Leitung 202 der Breitband-Lambdasonde und beispielsweise einer Batteriespannung ein Kurzschluss 300 auftritt. In diesem Fall fließt ein Zusatzstrom zu der Strommesseinrichtung 120. Der mit der Strommesseinrichtung 120 gemessene Wert Ip unterscheidet sich dann von dem für die Konstantstromquelle 110 spezifizierten Wert Iq um mehr als einen Schwellwert, obwohl im Beispiel das Potenzial Up noch innerhalb der vorgegebenen Schranken L1, L2 liegt

Eine Alternative des Beispiels sieht vor, dass zum Vergleich mit Ip nicht der für die Konstantstromquelle 110 spezifizierten Wert Iq verwendet wird, sondern dass in einem separaten Verfahrensschritt die Konstantstromquelle 110 innerhalb der Auswerte- und Steuereinheit mit der Strommesseinrichtung 120 verbunden wird, sodass der tatsächliche Wert Iq' der Konstantstromquelle 110 durch die Strommesseinrichtung 120 gemessen wird. Dieser gemessene tatsächliche Wert Iq' wird anstelle des spezifizierten Werts Iq anschließend zum Vergleich mit Ip benutzt, wie oben beschrieben.

## Patentansprüche

1. Verfahren zur Diagnose von elektrischen Leitungen (201, 202, 203, 204) einer Breitband-Lambdasonde (200), wobei die elektrischen Leitungen (201, 202, 203, 204) der Breitband-Lambdasonde (200) mit einem Anschluss (RE, IPN, APN, MES) einer Auswerte- und Steuereinheit (100), verbunden sind, wobei die Auswerte- und Steuereinheit, insbesondere als ASIC ausgebildet ist, und zum Betreiben einer Breitband-Lambdasonde (200) ausgebildet ist, wobei die Breitband-Lambdasonde (200) elektrische Leitungen (201, 202, 203, 204) aufweist, wobei die Auswerte- und Steuereinheit (100) elektrische Anschlüsse (RE, IPN, APN, MES) zur elektrischen Verbindung mit den elektrischen Leitungen (201, 202, 203, 204) der Breitband-Lambdasonde (200) aufweist, wobei die Auswerte- und Steuereinheit (100) vier elektrischen Anschlüsse (RE, IPN, APN, MES) aufweist, über die sie mit vier elektrischen Leitungen der Breitband-Lambdasonde verbunden ist, und dass die vier elektrischen Leitungen (201, 202, 203, 204) der Breitband-Lambdasonde zu Elektroden einer elektrochemischen Nernstzelle (210) und einer elektrochemischen Pumpzelle (211) der Breitband-Lambdasonde und zu einem ohmschen Widerstand (220) der Breitband-Lambdasonde (200) führen, wobei die Auswerte- und Steuereinheit (100) eine Einrichtung (131) zur Bestimmung eines Sollwerts (Iq) eines in die elektrischen Anschlüsse (RE, IPN, APN, MES) fließenden Stroms und zum Vergleich dieses Sollwerts (Iq) mit dem tatsächlich in die elektrischen Anschlüsse fließenden Strom (Ip) aufweist und wobei die Auswerte- und Steuereinheit (100) Komparatoren (130, 130') zum Vergleich des an den elektrischen Anschlüssen anliegenden elektrischen Potenzialen (Up) mit vorgegebenen Schranken (L1, L2) aufweist; wobei die Diagnose vorsieht, dass genau dann das Vorliegen eines Kurzschlusses oder Nebenschlusses (300) einer der elektrischen Leitungen (201, 202, 203, 204) ausgeschlossen wird, wenn weder das an dem zugehörigen Anschluss (RE, IPN, APN, MES) anliegende elektrische Potenzial (Up) außerhalb vorgegebener Schranken (L1, L2) liegt, noch der in den zugehörigen Anschluss (RE, IPN, APN, MES) fließende elektrische Strom (Ip) sich von einem Sollwert (Iq, I'q) um mehr als einen Schwellwert unterscheidet;
und/oder
genau dann auf einen Kurzschluss oder Nebenschluss (300) einer der elektrischen Leitung (201, 202, 203, 204) geschlossen wird, wenn zumindest eine der folgenden Bedingungen erfüllt ist:
- das an dem zugehörigen Anschluss (RE, IPN, APN, MES) anliegende elektrische Potenzial (Up) liegt außerhalb vorgegebener Schranken;
- der in den zugehörigen Anschluss (RE, IPN, APN, MES) fließende elektrische Strom (Ip) unterscheidet sich von einem Sollwert (Iq, I'q) um mehr als einen Schwellwert;
wobei durch das Verfahren die Diagnose zyklisch für alle Leitungen (201, 202, 203, 204) durchgeführt wird.

2. Verfahren nach dem vorangehenden Anspruch, **dadurch gekennzeichnet, dass** falls der in den zugehörigen Anschluss (RE, IPN, APN, MES) fließende elektrische Strom (Ip) sich von einem Sollwert (Iq, I'q) um mehr als einen Schwellwert unterscheidet weiter
- auf einen Kurzschluss oder Nebenschluss (300 ) nach Masse geschlossen wird, falls der elektrische Strom (Ip) kleiner ist als der Sollwert (Iq, I'q) und/oder
- auf einen Kurzschluss oder Nebenschluss nach einem Versorgungspotenzial geschlossen wird, falls der elektrische Strom (Ip) größer ist als der Sollwert (Iq, I'q).

3. Verfahren nach einem der vorangehenden Ansprüche, **dadurch gekennzeichnet, dass** falls das an dem zugehörigen Anschluss (RE, IPN, APN, MES) anliegende elektrische Potenzial (Up) außerhalb vorgegebener Schranken (L1, L2) liegt,
- auf einen Kurzschluss oder Nebenschluss (300) nach Masse geschlossen wird, falls das elektrische Potenzial (Up) unterhalb der vorgegebenen Schranken (L1, L2) liegt und/oder
- auf einen Kurzschluss oder Nebenschluss (300) nach einem Versorgungspotenzial oder nach einer Batteriespannung geschlossen wird, falls das elektrische Potenzial (Up) oberhalb der vorgegebenen Schranken (L1, L2) liegt.

4. Verfahren nach einem der vorangehenden Ansprüche, **dadurch gekennzeichnet, dass** der Sollwert (Iq, I'q) durch den für eine mit dem zugehörigen Anschluss (RE, IPN, APN, MES) verbundene Konstant-Stromquelle (110) der Steuer- und Auswerteeinheit (100) spezifizierten Stromwert (Iq) gegeben ist.

5. Verfahren nach einem der vorangehenden Ansprüche, **dadurch gekennzeichnet, dass** der Schwellwert durch eine erwartete Messgenauigkeit gegeben ist.

## Claims

1. Method for diagnosing electrical lines (201, 202, 203, 204) of a broadband lambda probe (200), wherein the electrical lines (201, 202, 203, 204) of the broadband lambda probe (200) are connected to a connection (RE, IPN, APN, MES) of an evaluation and control unit (100), wherein the evaluation and control unit is, in particular, in the form of an ASIC and is designed to operate a broadband lambda probe (200), wherein the broadband lambda probe (200) has electrical lines (201, 202, 203, 204), wherein the evaluation and control unit (100) has electrical connections (RE, IPN, APN, MES) for electrical connection to the electrical lines (201, 202, 203, 204) of the broadband lambda probe (200), wherein the evaluation and control unit (100) has four electrical connections (RE, IPN, APN, MES), via which it is connected to four electrical lines of the broadband lambda probe, and the four electrical lines (201, 202, 203, 204) of the broadband lambda probe lead to electrodes of an electrochemical Nernst cell (210) and of an electrochemical pump cell (211) of the broadband lambda probe and to an ohmic resistor (220) of the broadband lambda probe (200), wherein the evaluation and control unit (100) has a device (131) for determining a target value (Iq) of a current flowing into the electrical connections (RE, IPN, APN, MES) and for comparing this target value (Iq) with the current (Ip) actually flowing into the electrical connections, and wherein the evaluation and control unit (100) has comparators (130, 130') for comparing the electrical potential (Up) applied to the electrical connections with predefined limits (L1, L2); wherein the diagnosis provides for the presence of a short circuit or shunt circuit (300) of one of the electrical lines (201, 202, 203, 204) to be excluded precisely when neither the electrical potential (Up) applied to the associated connection (RE, IPN, APN, MES) is outside predefined limits (L1, L2) nor the electrical current (Ip) flowing into the associated connection (RE, IPN, APN, MES) differs from a target value (Iq, I'q) by more than a threshold value;
and/or
a short circuit or shunt circuit (300) of one of the electrical lines (201, 202, 203, 204) is inferred precisely when at least one of the following conditions is met:
- the electrical potential (Up) applied to the associated connection (RE, IPN, APN, MES) is outside predefined limits;
- the electrical current (Ip) flowing into the associated connection (RE, IPN, APN, MES) differs from a target value (Iq, I'q) by more than a threshold value;
wherein the diagnosis is cyclically carried out for all lines (201, 202, 203, 204) by means of the method.

2. Method according to the preceding claim, **characterized in that**, if the electrical current (Ip) flowing into the associated connection (RE, IPN, APN, MES) differs from a target value (Iq, I'q) by more than a threshold value
- a short circuit or shunt circuit (300) to earth is also inferred if the electrical current (Ip) is less than the target value (Iq, I'q) and/or
- a short circuit or shunt circuit to a supply potential is inferred if the electrical current (Ip) is greater than the target value (Iq, I'q).

3. Method according to one of the preceding claims, **characterized in that**, if the electrical potential (Up) applied to the associated connection (RE, IPN, APN, MES) is outside predefined limits (L1, L2),
- a short circuit or shunt circuit (300) to earth is inferred if the electrical potential (Up) is below the predefined limits (L1, L2) and/or
- a short circuit or shunt circuit (300) to a supply potential or to a battery voltage is inferred if the electrical potential (Up) is above the predefined limits (L1, L2).

4. Method according to one of the preceding claims, **characterized in that** the target value (Iq, I'q) is given by the current value (Iq) specified for a constant current source (110) of the control and evaluation unit (100) that is connected to the associated connection (RE, IPN, APN, MES).

5. Method according to one of the preceding claims, **characterized in that** the threshold value is given by an expected measurement accuracy.

## Revendications

1. Procédé de diagnostic des lignes électriques (201, 202, 203, 204) d'une sonde lambda à large bande (200), dans lequel les lignes électriques (201, 202, 203, 204) de la sonde lambda à large bande (200) sont reliées à une borne (RE, IPN, APN, MES) d'une unité d'évaluation et de commande (100), dans lequel l'unité d'évaluation et de commande est réalisée en particulier sous forme d'ASIC et est réalisée pour faire fonctionner une sonde lambda à large bande (200), dans lequel la sonde lambda à large bande (200) présente des lignes électriques (201, 202, 203, 204), dans lequel l'unité d'évaluation et de commande (100) présente des bornes électriques (RE, IPN, APN, MES) pour la liaison électrique avec les lignes électriques (201, 202, 203, 204) de la sonde lambda à large bande (200), dans lequel l'unité d'évaluation et de commande (100) présente quatre bornes électriques (RE, IPN, APN, MES) par lesquelles elle est reliée à quatre lignes électriques de la sonde lambda à large bande, et les quatre lignes électriques (201, 202, 203, 204) de la sonde lambda à large bande mènent aux électrodes d'une cellule de Nernst électrochimique (210) et d'une cellule de pompage électrochimique (211) de la sonde lambda à large bande et à une résistance ohmique (220) de la sonde lambda à large bande (200), dans lequel l'unité d'évaluation et de commande (100) présente un dispositif (131) pour déterminer une valeur de consigne (Iq) d'un courant circulant dans les bornes électriques (RE, IPN, APN, MES) et pour comparer cette valeur de consigne (Iq) avec le courant (Ip) circulant réellement dans les bornes électriques, et dans lequel l'unité d'évaluation et de commande (100) présente des comparateurs (130, 130') pour comparer le potentiel électrique (Up) appliqué aux bornes électriques avec des limites prédéfinies (L1, L2) ; dans lequel le diagnostic prévoit que la présence d'un court-circuit ou d'une dérivation (300) d'une des lignes électriques (201, 202, 203, 204) soit exclue exactement quand ni le potentiel électrique (Up) appliqué à la borne associée (RE, IPN, APN, MES) ne se trouve à l'extérieur des limites prédéfinies (L1, L2), ni le courant électrique (Ip) circulant dans la borne associée (RE, IPN, APN, MES) n'est différent d'une valeur de consigne (Iq, I'q) de plus d'une valeur seuil ;
et/ou
on conclut à un court-circuit ou à une dérivation (300) d'une des lignes électriques (201, 202, 203, 204) exactement quand au moins l'une des conditions suivantes est satisfaite :
- le potentiel électrique (Up) appliqué à la borne associée (RE, IPN, APN, MES) se trouve à l'extérieur des limites prédéfinies ;
- le courant électrique (Ip) circulant dans la borne associée (RE, IPN, APN, MES) se distingue d'une valeur de consigne (Iq, I'q) de plus d'une valeur seuil ;
dans lequel le procédé exécute le diagnostic de manière cyclique pour toutes les lignes électriques (201, 202, 203, 204).

2. Procédé selon la revendication précédente, **caractérisé en ce que** si le courant électrique (Ip) circulant dans la borne associée (RE, IPN, APN, MES) se distingue d'une valeur de consigne (Iq, I'q) de plus d'une valeur seuil, en outre
- on conclut à un court-circuit ou à une dérivation (300) à la masse si le courant électrique (Ip) est inférieur à la valeur de consigne (Iq, I'q), et/ou
- on conclut à un court-circuit ou à une dérivation à un potentiel d'alimentation si le courant électrique (Ip) est supérieur à la valeur de consigne (Iq, I'q).

3. Procédé selon l'une quelconque des revendications précédentes, **caractérisé en ce que** si le potentiel électrique (Up) appliqué à la borne associée (RE, IPN, APN, MES) se trouve à l'extérieur des limites prédéfinies (L1, L2),
- on conclut à un court-circuit ou à une dérivation (300) à la masse si le potentiel électrique (Up) se trouve au-dessous des limites prédéfinies (L1, L2), et/ou
- on conclut à un court-circuit ou à une dérivation (300) à un potentiel d'alimentation ou à une tension de batterie si le potentiel électrique (Up) se trouve au-dessus des limites prédéfinies (L1, L2).

4. Procédé selon l'une quelconque des revendications précédentes, **caractérisé en ce que** la valeur de consigne (Iq, I'q) est donnée par la valeur de courant (Iq) spécifiée pour une source de courant constant (110) de l'unité de commande et d'évaluation (100), reliée à la borne associée (RE, IPN, APN, MES).

5. Procédé selon l'une quelconque des revendications précédentes, **caractérisé en ce que** la valeur seuil est donnée par une précision de mesure attendue.
